# EUROPÄISCHE PATENTSCHRIFT

(11) **EP 2 274 774 B1**
(45) Veröffentlichungstag und Bekanntmachung des Hinweises auf die Patenterteilung: **05.06.2019**
(21) Anmeldenummer: 09741730.7
(22) Anmeldetag: 17.04.2009
(51) Int. Cl.: H01L 25/16, H01L 33/38, H01L 33/00

(54) **STRAHLUNGSEMITTIERENDER HALBLEITERCHIP**
RADIATION-EMITTING SEMICONDUCTOR CHIP
PUCE SEMI-CONDUCTRICE ÉMETTANT UN RAYONNEMENT

(30) Priorität: 09.05.2008 DE 102008022942
(43) Veröffentlichungstag der Anmeldung: 19.01.2011
(73) Patentinhaber: OSRAM Opto Semiconductors GmbH, 93055 Regensburg (DE)
(72) Erfinder: RODE, Patrick, 93051 Regensburg (DE); HÖPPEL, Lutz, 93087 Alteglofsheim (DE); ENGL, Karl, 93080 Niedergebraching (DE); ALBRECHT, Tony, 93077 Bad Abbach (DE)
(74) Vertreter: Epping - Hermann - Fischer
(86) Internationale Anmeldenummer: PCT/DE2009/000546
(87) Internationale Veröffentlichungsnummer: WO 2009/135457

(56) Entgegenhaltungen:
- EP-A- 1 577 958
- WO-A1-2005/112138
- CN-A- 1 564 333
- JP-A- 11 251 644
- US-A1- 2002 179 914
- US-A1- 2005 205 887
- US-A1- 2006 060 880
- US-A1- 2007 069 218

## Beschreibung

Die vorliegende Anmeldung betrifft einen strahlungsemittierenden Halbleiterchip.

Bei strahlungsemittierenden Halbleiterchips, etwa Leuchtdioden, kann elektrostatische Entladung zu deren Schädigung bis hin zur Zerstörung führen. Zur Vermeidung einer solchen Schädigung kann dem Halbleiterchip eine zusätzliche Diode parallel geschaltet werden, wobei die Durchlassrichtung der Diode antiparallel zu der Durchlassrichtung des strahlungsemittierenden Halbleiterchips ausgerichtet ist. Bei der Montage der Halbleiterchips wird diesen also eine zusätzliche Diode zugeordnet, was einen hohen Montageaufwand, hohe Herstellungskosten und einen erhöhten Platzbedarf verursachen kann.

Die Druckschrift US 2005/0205887 A1 betrifft eine LED mit einem Halbleiterkörper, der über Lötkontakte an einem Träger angebracht ist, der eine ESD-Diode bildet.

Aus der Druckschrift US 2002/0179914 A1 ist ein Bauteil bekannt, wobei in einem Träger für eine LED ein dotierter Bereich gebildet ist, der als ESD-Diode wirkt.

In den Druckschriften EP 1 577 958 A1 und WO 2005/112138 A1 sind LED-Chips beschrieben, bei denen ein Aufwachssubstrat von einem Halbleiterkörper entfernt ist.

Eine LED mit einer zusätzlichen Kontaktfläche an einer GaN-Schicht für eine ESD-Diode ist der Druckschrift US 2007/0069218 A1 zu entnehmen.

Gemäß der Druckschrift JP H11-251644 A ist in einer Radial-LED ein LED-Chip auf einer Silizium-Diode zum ESD-Schutz angebracht.

Die Druckschrift CN 1 564 333 A offenbart eine LED-Struktur an einem Träger, der als ESD-Schutzelement in Form einer Silizium-Diode oder einer Schottky-Diode wirkt, gemäß dem Oberbegriff des Anspruchs 1.

Es ist eine Aufgabe, einen strahlungsemittierenden Halbleiterchip anzugeben, der gegenüber elektrostatischer Entladung eine verringerte Empfindlichkeit aufweist.

Diese Aufgabe wird durch einen strahlungsemittierenden Halbleiterchip gemäß Patentanspruch 1 gelöst, der die vorliegende Erfindung definiert.

Erfindungsgemäß weist ein strahlungsemittierender Halbleiterchip einen Träger, einen Halbleiterkörper mit einer Halbleiterschichtenfolge, einen ersten Kontakt und einen zweiten Kontakt auf. Die Halbleiterschichtenfolge umfasst einen zur Erzeugung von Strahlung vorgesehenen aktiven Bereich, eine erste Halbleiterschicht und eine zweite Halbleiterschicht. Der aktive Bereich ist zwischen der ersten Halbleiterschicht und der zweiten Halbleiterschicht angeordnet. Der Träger weist eine dem Halbleiterkörper zugewandte Hauptfläche auf. Die erste Halbleiterschicht ist auf der der Hauptfläche des Trägers zugewandten Seite des aktiven Bereichs angeordnet und mittels des ersten Kontakts elektrisch kontaktierbar. Die zweite Halbleiterschicht ist mittels des zweiten Kontakts elektrisch kontaktierbar. Eine Schutzdiode ist in einem Strompfad ausgebildet, der zwischen dem ersten Kontakt und dem zweiten Kontakt durch den Träger verläuft.

Die Schutzdiode ist in den Halbleiterchip integriert. Über eine solche Schutzdiode kann eine ungewünschte, in Sperr-Richtung des Halbleiterchips an diesem anliegende Spannung abfließen. Die Schutzdiode erfüllt die Funktion einer ESD (electrostatic discharge)- Diode, die den Halbleiterchip vor einer Schädigung durch elektrostatische Entladung schützt. Die Gefahr einer Schädigung des Halbleiterchips kann so reduziert werden. Auf eine zusätzliche, außerhalb des Halbleiterchips anzuordnende und mit diesem elektrisch zu verbindende, Schutzdiode kann verzichtet werden.

Zweckmäßigerweise weist der Halbleiterchip zwischen dem ersten Kontakt und dem zweiten Kontakt zusätzlich zu dem Strompfad mit der Schutzdiode einen Injektionspfad auf, der durch den Halbleiterkörper, insbesondere durch den aktiven Bereich, verläuft.

Der Strompfad, in dem die Schutzdiode ausgebildet ist, verläuft außerhalb des Halbleiterkörpers. Mit anderen Worten fließen die Ladungsträger, die über die Schutzdiode zwischen den Kontakten abfließen, nicht durch den Halbleiterkörper hindurch.

Die erste Halbleiterschicht und die zweite Halbleiterschicht des Halbleiterkörpers sind bezüglich ihres Leitungstyps voneinander verschieden. Beispielsweise kann die erste Halbleiterschicht p-leitend und die zweite Halbleiterschicht n-leitend ausgebildet sein oder umgekehrt.

Eine Diodenstruktur, in der der aktive Bereich ausgebildet ist, ist so auf einfache Weise realisiert.

Bezüglich der Durchlassrichtung sind die Diodenstruktur des Halbleiterkörpers und die Schutzdiode zueinander antiparallel ausgebildet. Eine an der Diodenstruktur in Durchlassrichtung zwischen dem ersten Kontakt und dem zweiten Kontakt anliegende Betriebsspannung bewirkt eine Injektion von Ladungsträgern von verschiedenen Seiten des aktiven Bereichs in den aktiven Bereich. Im aktiven Bereich können die Ladungsträger unter Emission von Strahlung rekombinieren.

Durch die Schutzdiode, welche bei der Betriebsspannung des Halbleiterchips in Sperr-Richtung betrieben wird, erfolgt in diesem Fall kein oder zumindest kein wesentlicher Stromfluss. Dagegen kann eine in Sperr-Richtung an der Diodenstruktur anliegende elektrische Spannung, etwa aufgrund elektrostatischer Aufladung, über die Schutzdiode abfließen. So kann der Halbleiterkörper durch die in den Halbleiterchip integrierte Schutzdiode geschützt werden, ohne dass die optoelektronischen Eigenschaften des Halbleiterchips wesentlich beeinträchtigt werden.

Erfindungsgemäß ist die Schutzdiode mittels des Trägers gebildet. Die Schutzdiode ist außerhalb des Halbleiterkörpers ausgebildet. Der Halbleiterkörper kann also ausschließlich zur Erzeugung von Strahlung vorgesehen sein. Die Schutzdiode kann derart in den Halbleiterchip integriert sein, dass die für die Strahlungserzeugung nutzbare Fläche des aktiven Bereichs bei gleicher Grundfläche des Halbleiterchips beibehalten werden kann.

Erfindungsgemäß ist der Halbleiterkörper stoffschlüssig mit dem Träger verbunden. Der Träger ist von einem Aufwachssubstrat für die Halbleiterschichtenfolge des Halbleiterkörpers verschieden.

Bei einer stoffschlüssigen Verbindung werden die Verbindungspartner, die vorgefertigt sind, mittels atomarer und/oder molekularer Kräfte zusammengehalten. Eine stoffschlüssige Verbindung kann beispielsweise mittels einer Verbindungsschicht, etwa einer Klebeschicht oder einer Lotschicht, erzielt werden. In der Regel geht eine Trennung der Verbindung mit der Zerstörung der Verbindungsschicht und/oder zumindest eines der Verbindungspartner einher.

In vertikaler Richtung, also senkrecht zu einer Haupterstreckungsebene der Halbleiterschichten des Halbleiterkörpers erstreckt sich der Träger vorzugsweise zwischen der Hauptfläche und einer weiteren Hauptfläche. Die Hauptfläche des Trägers ist vorzugsweise eben ausgeführt. Eine zuverlässige Befestigung des Halbleiterkörpers an dem Träger ist so auf einfache Weise herstellbar. Weiterhin ist die weitere Hauptfläche vorzugsweise eben ausgeführt. So kann der Halbleiterchip seitens der weiteren Hauptfläche vereinfacht montiert werden, etwa in einem Gehäuse oder auf einem Anschlussträger.

Der Träger enthält weiterhin bevorzugt ein Halbleitermaterial oder besteht aus einem Halbleitermaterial. Insbesondere Silizium hat sich als besonders geeignet herausgestellt. Auch andere Halbleitermaterialien, etwa Germanium oder Galliumarsenid, können als Material für den Träger verwendet werden.

In einer weiteren bevorzugten Ausgestaltung ist der Träger zumindest bereichsweise dotiert gebildet. Das Ausbilden einer Schutzdiode mittels des Trägers kann so vereinfacht werden.

In einer weiteren bevorzugten Ausgestaltung ist der erste Kontakt auf der Hauptfläche des Trägers angeordnet. Der erste Kontakt kann in lateraler Richtung, also einer entlang der Haupterstreckungsrichtung der Halbleiterschichten des Halbleiterkörpers verlaufenden Richtung, von dem aktiven Bereich beabstandet sein. Die erste Halbleiterschicht und der zugeordnete erste Kontakt können weiterhin auf derselben Seite des Trägers angeordnet sein.

Erfindungsgemäß ist zwischen dem Halbleiterkörper und dem Träger eine erste Anschlussschicht angeordnet. Die erste Halbleiterschicht ist mit der ersten Anschlussschicht elektrisch leitend verbunden. Vorzugsweise ist zwischen der ersten Anschlussschicht und der ersten Halbleiterschicht ein ohmscher Kontakt ausgebildet, das heißt, die Strom-Spannungs-Kennlinie des Kontakts verläuft linear oder zumindest näherungsweise linear.

Erfindungsgemäß weist der Halbleiterkörper zumindest eine Ausnehmung auf, die sich durch den aktiven Bereich hindurch erstreckt und die für die elektrische Kontaktierung der zweiten Halbleiterschicht vorgesehen ist. Die Ausnehmung erstreckt sich von der Seite des Trägers her durch den aktiven Bereich hindurch.

Erfindungsgemäß ist die zweite Halbleiterschicht mit einer zweiten Anschlussschicht elektrisch leitend verbunden, wobei sich die zweite Anschlussschicht durch die Ausnehmung hindurch erstreckt.

Mittels der Ausnehmung ist die zweite Halbleiterschicht von der dem Träger zugewandten Seite des aktiven Bereichs her elektrisch kontaktierbar.

Eine Strahlungsaustrittsfläche des Halbleiterchips, die auf der dem Träger abgewandten Seite des aktiven Bereichs ausgebildet ist, kann frei von einem externen elektrischen Kontakt für den Halbleiterkörper sein. Eine Abschattung der Strahlungsaustrittsfläche durch einen strahlungsundurchlässigen Kontakt kann so vermieden werden. Somit können die erste Halbleiterschicht und die zweite Halbleiterschicht von der dem Träger zugewandten Seite des aktiven Bereichs elektrisch angeschlossen sein.

Erfindungsgemäß ist die zweite Anschlussschicht bereichsweise zwischen der ersten Anschlussschicht und dem Träger ausgebildet. Zwischen der ersten Anschlussschicht und der zweiten Anschlussschicht ist vorzugsweise eine Isolationsschicht vorgesehen.

In einer weiteren bevorzugten Weiterbildung ist die Verbindungsschicht zwischen der zweiten Anschlussschicht und dem Träger angeordnet.

Die Verbindungsschicht bedeckt den Träger vorzugsweise nur bereichsweise. Insbesondere kann ein Bereich der Hauptfläche des Trägers, in dem die Schutzdiode ausgebildet ist, zumindest teilweise frei von der Verbindungsschicht sein.

Erfindungsgemäß sind der erste Kontakt und der zweite Kontakt auf gegenüberliegenden Seiten des Trägers angeordnet. Der Strompfad, in dem die Schutzdiode ausgebildet ist, erstreckt sich in diesem Fall in vertikaler Richtung durch den Träger hindurch.

Insbesondere kann der zweite Kontakt auf der dem Halbleiterkörper abgewandten Seite des Trägers angeordnet und weiterhin für die Montage des strahlungsemittierenden Halbleiterchips, etwa in einem Gehäusekörper oder auf einem Anschlussträger, vorgesehen sein.

In einer weiteren bevorzugten Ausgestaltung ist die Schutzdiode als eine Schottky-Diode ausgeführt. Eine Schottky-Diode kann insbesondere mittels eines Metall-Halbleiter-Übergangs gebildet sein, wobei die Strom-Spannungs-Kennlinie des Übergangs von einer ohmschen Charakteristik abweicht.

Weiterhin bevorzugt ist die Schutzdiode zwischen dem ersten Kontakt und dem Träger ausgebildet. Insbesondere kann die Schutzdiode mittels eines Metall-Halbleiter-Übergangs ausgebildet sein, wobei die Hauptfläche des Trägers den Metall-Halbleiter-Übergang bildet. Die Hauptfläche des Trägers kann also bereichsweise als eine Grenzfläche eines Metall-Halbleiter-Übergangs dienen.

In einer weiteren bevorzugten Ausgestaltung weist die erste Anschlussschicht eine Injektionsschicht auf, die an den Halbleiterkörper, insbesondere an die erste Halbleiterschicht angrenzt. Die Injektionsschicht ist vorzugsweise derart ausgeführt, dass sie zum Halbleiterkörper einen ohmschen Kontakt herstellt. Die Injektionsschicht kann auch mehrschichtig ausgebildet sein.

Weiterhin bevorzugt weist die Injektionsschicht oder zumindest eine an den Halbleiterkörper angrenzende Teilschicht der Injektionsschicht für die im aktiven Bereich erzeugte Strahlung eine hohe Reflektivität auf. Im aktiven Bereich erzeugte und in Richtung des Trägers abgestrahlte Strahlung kann so zur Strahlungsaustrittsfläche hin umgelenkt werden. Die Gefahr einer Absorption der Strahlung im Träger kann vermieden werden. Beispielsweise eignet sich als Material mit hoher Reflektivität für Strahlung im sichtbaren und ultravioletten Spektralbereich insbesondere Silber, Aluminium oder Rhodium, im roten und infraroten Spektralbereich insbesondere Gold.

Weiterhin bevorzugt weist die erste Anschlussschicht eine Übergangsschicht auf, die an den Träger angrenzt.

In einer bevorzugten Weiterbildung ist die Schutzdiode mittels der ersten Anschlussschicht, insbesondere mittels der Übergangsschicht, gebildet. Insbesondere kann die erste Anschlussschicht mit dem Träger einen Schottky-Kontakt bilden.

Die erste Anschlussschicht kann also so ausgeführt sein, dass sie zu dem Halbleiterkörper, insbesondere zu der ersten Halbleiterschicht, einen ohmschen Kontakt und zu dem Träger einen Schottky-Kontakt ausbildet. Mit anderen Worten kann die erste Anschlussschicht zum einen dazu dienen, einen elektrischen Kontakt zum Halbleiterkörper herzustellen und zum anderen, um die in den Halbleiterchip integrierte Schutzdiode auszubilden.

Die erste Anschlussschicht ist weiterhin bevorzugt als eine zusammenhängende Schicht ausgeführt.

In einer bevorzugten Weiterbildung überlappt die Schutzdiode in Aufsicht auf den Halbleiterchip mit dem ersten Kontakt. Die Schutzdiode kann in Aufsicht also in einem Bereich ausgebildet sein, der für die externe elektrische Kontaktierung des Halbleiterchips, etwa mittels eines Bonddrahts, vorgesehen ist. Auf diese Weise kann die Schutzdiode ohne zusätzlichen Platzbedarf im Halbleiterchip ausgebildet werden. Insbesondere kann die Schutzdiode außerhalb des Halbleiterkörpers in den Halbleiterchip integriert sein, ohne dass die für die Strahlungserzeugung im Halbleiterchip nutzbare Fläche des aktiven Bereichs verringert ist.

Weiterhin bevorzugt ist die Schutzdiode in Aufsicht auf den Halbleiterchip in einem Bereich ausgebildet, in dem der Halbleiterkörper, insbesondere in vertikaler Richtung vollständig, entfernt ist.

Bei der Herstellung des Halbleiterchips kann das Ausbilden der Schutzdiode dadurch erfolgen, dass der Träger durch Entfernen des Halbleiterkörpers und gegebenenfalls der Verbindungsschicht bereichsweise freigelegt wird. In dem freigelegten Bereich kann Material für die erste Anschlussschicht, insbesondere für die Übergangsschicht auf der Hauptfläche des Trägers abgeschieden werden. Die Herstellung der Schutzdiode ist so auf einfache Weise realisiert.

Die Halbleiterschichtenfolge des Halbleiterkörpers ist vorzugsweise epitaktisch, etwa mittels MOVPE oder MBE, abgeschieden.

Weiterhin bevorzugt enthält der Halbleiterkörper, insbesondere der aktive Bereich, ein III-V-Halbleitermaterial. Mit III-V-Halbleitermaterialien können bei der Strahlungserzeugung hohe interne Quanteneffizienzen erreicht werden.

Der beschriebene Aufbau ist generell für strahlungsemittierende Haubleiterchips geeignet, wobei die Halbleiterchips zur Erzeugung von inkohärenter, teilkohärenter oder kohärenter Strahlung vorgesehen sein können.

In einer bevorzugten Ausgestaltung ist der Halbleiterchip als ein Leuchtdioden-Halbleiterchip ausgeführt, der weiterhin bevorzugt zur Erzeugung von inkohärenter oder teilkohärenter Strahlung vorgesehen ist.

Erfindungsgemäß ist ein Aufwachssubstrat für die Halbleiterschichtenfolge des Halbleiterkörpers entfernt. Ein Halbleiterchip, bei dem das Aufwachssubstrat entfernt ist, wird auch als Dünnfilm-Halbleiterchip bezeichnet.

Ein Dünnfilm-Halbleiterchip, etwa ein Dünnfilm-Leuchtdioden-Halbleiterchip, kann sich weiterhin im Rahmen der vorliegenden Anmeldung durch mindestens eines der folgenden charakteristischen Merkmale auszeichnen:
- an einer zum Träger hin gewandten ersten Hauptfläche eines Halbleiterkörpers, der eine Halbleiterschichtenfolge mit einem aktiven Bereich umfasst, insbesondere einer Epitaxieschichtenfolge, ist eine Spiegelschicht aufgebracht oder, etwa als Braggspiegel in der Halbleiterschichtenfolge integriert, ausgebildet, die zumindest einen Teil der in der Halbleiterschichtenfolge erzeugten Strahlung in diese zurückreflektiert;
- die Halbleiterschichtenfolge weist eine Dicke im Bereich von 20µm oder weniger, insbesondere im Bereich von 10 µm auf; und/oder
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, d.h. sie weist ein möglichst ergodisch stochastisches Streuverhalten auf.

Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben.

Weitere Merkmale, Ausgestaltungen und Zweckmäßigkeiten ergeben sich aus der folgenden Beschreibung der Ausführungsbeispiele in Verbindung mit den Figuren.

Es zeigen:
- die Figuren 1A und 1B: ein Ausführungsbeispiel für einen strahlungsemittierenden Halbleiterchip in schematischer Aufsicht (Figur 1B) und zugehöriger Schnittansicht (Figur 1A); und
- Figur 2: eine schematische Darstellung der Strompfade in einem Halbleiterchip gemäß dem in den Figuren 1A und 1B dargestellten Ausführungsbeispiel.

Gleiche, gleichartige und gleich wirkende Elemente sind in den Figuren mit gleichen Bezugszeichen versehen.

Die Figuren sind jeweils schematische Darstellungen und daher nicht unbedingt maßstabsgetreu. Vielmehr können vergleichsweise kleine Elemente und insbesondere Schichtdicken zur Verdeutlichung übertrieben groß dargestellt sein.

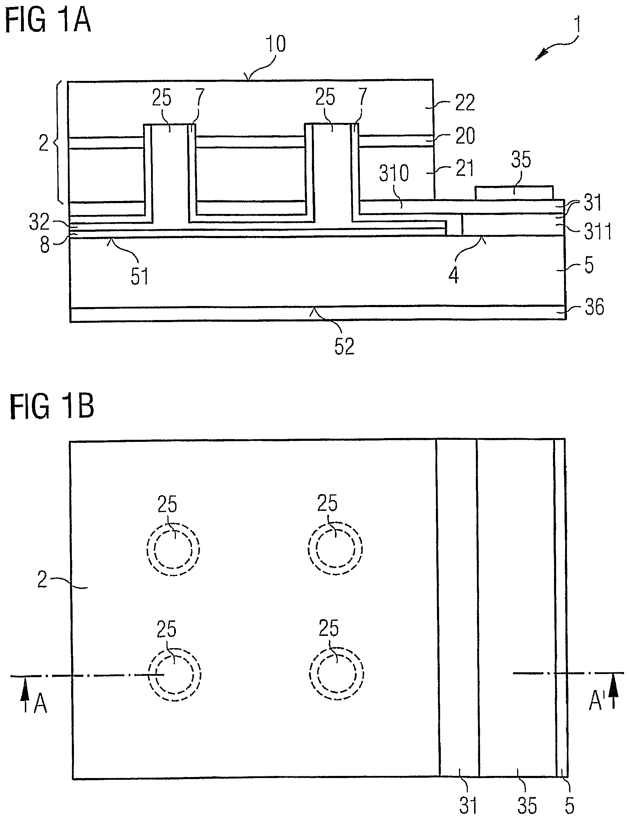

Ein Ausführungsbeispiel für einen strahlungsemittierenden Halbleiterchip 1 ist in Figur 1B in schematischer Aufsicht und in Figur 1A in zugehöriger schematischer Schnittansicht entlang der Linie AA' dargestellt. Der Halbleiterchip 1 weist einen Halbleiterkörper 2 mit einer Halbleiterschichtenfolge auf. Die Halbleiterschichtenfolge bildet den Halbleiterkörper 2 und ist vorzugsweise epitaktisch, etwa mittels MOVPE oder MBE, hergestellt.

Weiterhin umfasst der strahlungsemittierende Halbleiterchip 1 einen Träger 5 mit einer Hauptfläche 51 und einer der Hauptfläche gegenüberliegenden weiteren Hauptfläche 52.

Der Halbleiterkörper 2 ist auf der Hauptfläche 51 des Trägers 5 angeordnet und mittels einer Verbindungsschicht 8 stoffschlüssig mit dem Träger 5 verbunden. Die Verbindungsschicht kann beispielsweise eine Lotschicht oder eine elektrisch leitfähige Klebeschicht sein.

Der Träger 5 enthält ein Halbleitermaterial oder besteht aus einem Halbleitermaterial. Insbesondere kann der Träger 5 Silizium enthalten oder aus Silizium bestehen. Auch ein anderes Halbleitermaterial, etwa Germanium oder Galliumarsenid, kann als Trägermaterial herangezogen werden.

Die Halbleiterschichtenfolge des Halbleiterkörpers 2 weist einen zur Erzeugung von Strahlung vorgesehenen aktiven Bereich 20 auf, der zwischen einer ersten Halbleiterschicht 21 und einer zweiten Halbleiterschicht 22 angeordnet ist. Die erste Halbleiterschicht 21 ist auf der dem Träger 5 zugewandten Seite des aktiven Bereichs angeordnet.

Weiterhin weist der Halbleiterchip 1 einen ersten Kontakt 35 und einen zweiten Kontakt 36 auf. Durch Anlegen einer externen elektrischen Spannung zwischen dem ersten Kontakt und dem zweiten Kontakt können im Betrieb des Halbleiterchips Ladungsträger von verschiedenen Seiten des aktiven Bereichs 20 in diesen injiziert werden und dort unter Emission von Strahlung rekombinieren.

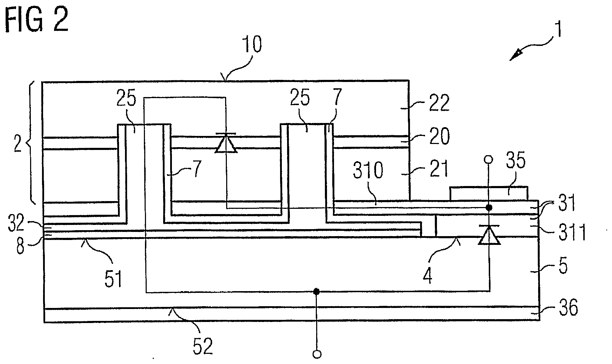

In einem Strompfad, der durch den Träger 5 zwischen dem ersten Kontakt 35 und dem zweiten Kontakt 36 verläuft, ist eine Schutzdiode 4 ausgebildet. Die Funktionsweise der Schutzdiode wird im Zusammenhang mit Figur 2 näher beschrieben.

Der Halbleiterkörper 2 weist Ausnehmungen 25 auf, die sich durch die erste Halbleiterschicht 21 und den aktiven Bereich 20 hindurch in die zweite Halbleiterschicht 22 hinein erstrecken. Die Ausnehmungen sind für eine elektrische Kontaktierung der zweiten Halbleiterschicht 22 von der dem Träger 5 zugewandten Seite des aktiven Bereichs her vorgesehen. Die Dichte und die Anordnung der Ausnehmungen sind zweckmäßigerweise derart gewählt, dass die Injektion der Ladungsträger über die zweite Halbleiterschicht 22 in den aktiven Bereich lateraler Richtung gleichmäßig erfolgt. Hierfür ist beispielsweise eine matrixartige Anordnung der Ausnehmungen geeignet.

Auf der dem Träger 5 abgewandten Seite des aktiven Bereichs 20 weist der Halbleiterkörper 2 eine Strahlungsaustrittsfläche 10 auf, durch die im Betrieb des Halbleiterchips im aktiven Bereich 20 erzeugte Strahlung austreten kann.

Die Strahlungsaustrittsfläche 10 ist frei von einem externen elektrischen Kontakt für den Halbleiterchip 1. Die Gefahr einer Abschattung der Strahlungsaustrittsfläche durch einen für die im aktiven Bereich 20 erzeugte Strahlung nicht transparenten Kontakt kann so vermieden werden. Die aus dem Halbleiterchip insgesamt austretende Strahlungsleistung kann so gesteigert werden.

Der erste Kontakt 35 ist über eine erste Anschlussschicht 31 mit der ersten Halbleiterschicht 21 elektrisch leitend verbunden. Die erste Anschlussschicht 31 ist zwischen dem Halbleiterkörper 2 und dem Träger 5 angeordnet. Die Anschlussschicht 31 bildet zu der ersten Halbleiterschicht 21 vorzugsweise einen ohmschen Kontakt, so dass Ladungsträger effizient in den Halbleiterkörper 2 injiziert werden können.

In dem gezeigten Ausführungsbeispiel ist die erste Anschlussschicht 31 mehrschichtig ausgebildet. Auf der dem Halbleiterkörper 2 zugewandten Seite weist die erste Anschlussschicht eine Injektionsschicht 310 auf. Die Injektionsschicht 310 ist vorzugsweise derart ausgebildet, dass sie zur ersten Halbleiterschicht 21 einen ohmschen Kontakt herstellt.

Die Injektionsschicht 310 kann auch mehrschichtig ausgebildet sein. Auf der der ersten Halbleiterschicht 21 zugewandten Seite weist die Injektionsschicht vorzugsweise eine hohe Reflektivität für die im aktiven Bereich 20 erzeugte Strahlung auf. Im ultravioletten und blauen Spektralbereich eignet sich beispielsweise Silber, im roten und infraroten Spektralbereich beispielsweise Gold.

Weiterhin kann die erste Anschlussschicht 31, insbesondere die Injektionsschicht 310, die Funktion einer Diffusionsbarriere erfüllen und beispielsweise Titan und/oder Platin enthalten.

An den Träger 5 angrenzend weist die erste Anschlussschicht 31 eine Übergangsschicht 311 auf. Die Übergangsschicht 311 bildet mit der Hauptfläche 51 des Trägers 5 einen Schottky-Kontakt. Das Material der Übergangsschicht ist zweckmäßigerweise derart auf den Träger 5 abgestimmt, dass ein Schottky-Kontakt auf einfache Weise realisierbar ist. Bei einem Silizium-Träger eignet sich beispielsweise Aluminium für die Übergangsschicht.

Weiterhin ist zwischen dem Träger 5 und dem Halbleiterkörper 2 eine zweite Anschlussschicht 32 ausgebildet. Diese zweite Anschlussschicht 32 erstreckt sich durch die Ausnehmungen 25 hindurch bis zu der zweiten Halbleiterschicht 22. Auf der dem Halbleiterkörper 2 abgewandten Seite der zweiten Anschlussschicht 32 ist die Verbindungsschicht 8 angeordnet. Über die Verbindungsschicht 8 ist eine elektrisch leitende Verbindung zwischen der zweiten Halbleiterschicht 22 und dem Träger 5 hergestellt.

Die Seitenflächen der Ausnehmungen 25 sind mit einer Isolationsschicht 7 bedeckt. Mittels dieser Isolationsschicht kann ein elektrischer Kurzschluss des aktiven Bereichs 20 durch die zweite Anschlussschicht 32 vermieden werden. Die Isolationsschicht 7 verläuft weiterhin zwischen der ersten Anschlussschicht 31 und der zweiten Anschlussschicht 32 und trennt diese Anschlussschichten elektrisch voneinander.

Die Isolationsschicht 7 kann beispielsweise ein Oxid, etwa Siliziumoxid oder Titanoxid, ein Nitrid, etwa Siliziumnitrid, oder ein Oxinitrid, etwa Siliziumoxinitrid, enthalten oder aus einem solchen Material bestehen.

Die erste Anschlussschicht 31, insbesondere die Injektionsschicht 310 und die Übergangsschicht 311, die zweite Anschlussschicht 32, der erste Kontakt 35 und der zweite Kontakt 36 enthalten vorzugsweise jeweils ein Metall oder bestehen aus einem Metall oder einer metallischen Legierung. Die genannten, außerhalb des Halbleiterkörpers 2 angeordneten, Schichten können beispielsweise mittels Aufdampfens oder Aufsputterns aufgebracht sein.

Der erste Kontakt 35 und der zweite Kontakt 36 sind auf unterschiedlichen Seiten des Trägers 5 angeordnet. Der erste Kontakt 35 ist beispielsweise mittels eines Bond-Drahts extern elektrisch kontaktierbar. Von dem gezeigten Ausführungsbeispiel abweichend kann der erste Kontakt 35 auch mittels der ersten Anschlussschicht 31 gebildet sein. Ein separater, zusätzlich zur ersten Anschlussschicht 31 vorgesehener Kontakt, ist in diesem Fall also nicht erforderlich.

Die Schutzdiode 4 in dem Strompfad zwischen dem ersten Kontakt 35 und dem zweiten Kontakt 36 ist als eine Schottky-Diode ausgeführt, die an der Hauptfläche 51 des Trägers 5 gebildet ist. Im Bereich der Schutzdiode 4 besteht zwischen dem Träger 5 und der ersten Anschlussschicht 31, insbesondere zwischen dem Träger 5 und der Übergangsschicht 311, ein Metall-Halbleiter-Übergang.

Die Schutzdiode 4 ist somit in einem Bereich ausgebildet, in dem der Halbleiterkörper 2 in vertikaler Richtung vollständig entfernt ist.

Der Träger 5 weist vorzugsweise denselben Leitungstyp auf wie die zweite Halbleiterschicht 22. Eine elektrische Kontaktierung der zweiten Halbleiterschicht 22 durch den Träger 5 hindurch wird so vereinfacht.

Die erste Halbleiterschicht 21 und die zweite Halbleiterschicht 22 sind bezüglich ihres Leitungstyps zweckmäßigerweise voneinander verschieden. Eine Diodenstruktur, in der der aktive Bereich 20 ausgebildet ist, ist so auf einfache Weise realisiert. In dem in den Figuren 1A, 1B und 2 dargestellten Ausführungsbeispiel ist lediglich exemplarisch die erste Halbleiterschicht 21 p-leitend dotiert und die zweite Halbleiterschicht 22 ebenso wie der Träger 5 n-leitend dotiert.

Bezüglich der Durchlassrichtung ist die Schutzdiode 4 antiparallel zu der Durchlassrichtung der Diodenstruktur des Halbleiterkörpers 2 ausgebildet. Die Strompfade in dem Halbleiterchip 1 sind in Figur 2 schematisch veranschaulicht. Bei Anliegen einer positiven elektrischen Spannung an dem ersten Kontakt 35 relativ zum zweiten Kontakt 36 wird die zur Erzeugung von Strahlung vorgesehene Diodenstruktur des Halbleiterkörpers 2 in Durchlassrichtung betrieben, so dass Ladungsträger in den aktiven Bereich 20 injiziert werden und dort unter Emission von Strahlung rekombinieren können.

Die Schutzdiode 4 ist bei dieser Polarität dagegen in Sperr-Richtung geschaltet. Im Falle einer elektrostatischen Aufladung der Diodenstruktur des Halbleiterkörpers in Sperr-Richtung aber können Ladungsträger über den Strompfad zwischen dem ersten Kontakt 35 und dem zweiten Kontakt 36 über die Schutzdiode 4 abfließen. Die Gefahr einer Schädigung des Halbleiterchips kann so vermindert werden. Auf eine außerhalb des Halbleiterchips ausgebildete Schutzdiode, die antiparallel zum ersten Kontakt 35 und zweiten Kontakt 36 des Halbleiterchips geschaltet ist, kann verzichtet werden.

In dem alternativen Fall, dass die erste Halbleiterschicht 21 n-leitend und die zweite Halbleiterschicht 22 sowie der Träger 5 p-leitend dotiert sind, kann der Halbleiterchip entsprechend so betrieben werden, dass an dem ersten Kontakt 35 relativ zum zweiten Kontakt 36 eine negative Spannung anliegt.

Mit der Anschlussschicht 31 kann zum einen ein ohmscher Kontakt zum Halbleiterkörper 2 und zum anderen ein Schottky-Kontakt zum Träger 5 hergestellt werden. Mittels der zur elektrischen Kontaktierung des Halbleiterkörpers 2 vorgesehenen ersten Anschlussschicht 31 kann also zusätzlich die Schutzdiode gebildet sein.

Die Schutzdiode 4 kann hierbei in Aufsicht auf den Halbleiterchip unterhalb des ersten Kontakts 35 ausgebildet sein. Die Schutzdiode kann so ohne zusätzlichen Flächenbedarf in den Halbleiterchip 1 integriert sein. Weiterhin ist die Schutzdiode 4 außerhalb des Halbleiterkörpers 2 angeordnet. Der epitaktisch gewachsene Halbleiterkörper kann also ausschließlich zur Erzeugung von Strahlung vorgesehen sein. Somit kann die Schutzdiode in den Halbleiterchip integriert sein, ohne dass die zur Strahlungserzeugung nutzbare Fläche des aktiven Bereichs verringert wird.

Weiterhin kann das Ausbilden der Schutzdiode 4 bei der Herstellung des Halbleiterchips 1 noch im Verbund erfolgen. Das heißt, beim Vereinzeln des Verbunds gehen Halbleiterchips mit jeweils auf einem Träger angeordneten Halbleiterkörpern hervor, wobei in den Halbleiterchips bereits die Schutzdiode ausgebildet ist. Ein Halbleiterchip mit integrierter Schutzdiode kann so besonders kostengünstig hergestellt werden.

Zudem benötigt der beschriebene Halbleiterchip mit integrierter Schutzdiode im Vergleich zu einem Halbleiterchip mit zusätzlicher externer Schutzdiode wenig Montagefläche. Die Herstellung eines kompakten Bauelements mit einem solchen Halbleiterchip als Strahlungsquelle ist somit vereinfacht. Weiterhin kann die Gefahr vermieden werden, dass die separate Schutzdiode eine Absorption der im aktiven Bereich erzeugten Strahlung verursacht.

In dem gezeigten Ausführungsbeispiel ist der Halbleiterchip 1 als ein Dünnfilm-Halbleiterchip ausgeführt, bei dem ein Aufwachssubstrat für die Halbleiterschichtenfolge des Halbleiterkörpers 2 entfernt ist. Der Träger 5 dient hierbei der mechanischen Stabilisierung des Halbleiterkörpers 2.

Davon abweichend kann das Aufwachssubstrat auch nur bereichsweise entfernt sein.

Der Halbleiterkörper, insbesondere der aktive Bereich 20, enthält vorzugsweise ein III-V-Halbleitermaterial.

III-V-Halbleitermaterialien sind zur Strahlungserzeugung im ultravioletten (InₓGa_{y}Al_{1-x-y}N) über den sichtbaren (InₓGa_{y}Al_{1-x-y}N, insbesondere für blaue bis grüne Strahlung, oder InₓGa_{y}Al_{1-x-y}P, insbesondere für gelbe bis rote Strahlung) bis in den infraroten (InₓGa_{y}Al_{1-x-y}As) Spektralbereich besonders geeignet. Hierbei gilt jeweils 0 ≤ x ≤ 1, 0 ≤ y ≤ 1 und x + y ≤ 1, insbesondere mit x ≠ 1, y ≠ 1, x ≠ 0 und/oder y ≠ 0. Mit III-V-Halbleitermaterialien, insbesondere aus den genannten Materialsystemen, können weiterhin bei der Strahlungserzeugung hohe interne Quanteneffizienzen erzielt werden.

Die Erfindung ist nicht durch die Beschreibung anhand der Ausführungsbeispiele beschränkt.

## Patentansprüche

1. Strahlungsemittierender Halbleiterchip (1), der einen Träger (5), einen Halbleiterkörper (2) mit einer Halbleiterschichtenfolge, einen ersten Kontakt (35) und einen zweiten Kontakt (36) aufweist, wobei
- die Halbleiterschichtenfolge einen zur Erzeugung von Strahlung vorgesehenen aktiven Bereich (20) umfasst, der zwischen einer ersten Halbleiterschicht (21) und einer zweiten Halbleiterschicht (22) angeordnet ist;
- der Träger (5) eine dem Halbleiterkörper (2) zugewandte Hauptfläche (51) aufweist;
- ein Aufwachssubstrat für die Halbleiterschichtenfolge des Halbleiterkörpers (2) entfernt ist und der Träger (5) den Halbleiterkörper mechanisch stabilisiert;
- die erste Halbleiterschicht (21) auf der der Hauptfläche (51) des Trägers (5) zugewandten Seite des aktiven Bereichs (20) angeordnet ist und mittels des ersten Kontakts (35) elektrisch kontaktierbar ist;
- die zweite Halbleiterschicht (22) mittels des zweiten Kontakts (36) elektrisch kontaktierbar ist;
- eine Schutzdiode (4) in einem Strompfad ausgebildet ist, der zwischen dem ersten Kontakt (35) und dem zweiten Kontakt (36) durch den Träger (5) verläuft;
- der erste Kontakt (35) über eine erste Anschlussschicht (31) mit der ersten Halbleiterschicht (21) elektrisch leitend verbunden ist und die erste Anschlussschicht (31) zwischen dem Halbleiterkörper (2) und dem Träger (5) angeordnet ist;
- der Halbleiterkörper (2) zumindest eine Ausnehmung (25) aufweist, die sich durch den aktiven Bereich (20) hindurch erstreckt und die für die elektrische Kontaktierung der zweiten Halbleiterschicht (22) vorgesehen ist, und
- die zweite Halbleiterschicht (22) mit einer zweiten Anschlussschicht (32) elektrisch leitend verbunden ist und sich die zweite Anschlussschicht (32) durch die Ausnehmung (25) hindurch erstreckt,
**dadurch gekennzeichnet, dass**
- sich die erste Anschlussschicht (31) und die zweite Anschlussschicht (32) aufeinanderfolgend zwischen dem Träger (5) und dem Halbleiterkörper befinden, sodass sich die zweite Anschlussschicht (32) näher am Träger (5) befindet als die erste Anschlussschicht (31),
- der erste Kontakt (35) und der zweite Kontakt (36) auf unterschiedlichen Seiten des Trägers (5) angeordnet sind, und
- der Halbleiterkörper (2) stoffschlüssig mit dem Träger (5) verbunden ist.

2. Halbleiterchip nach Anspruch 1,
bei dem die Schutzdiode (4) eine Schottky-Diode ist, die zwischen dem ersten Kontakt (35) und dem Träger (5) ausgebildet ist.

3. Halbleiterchip nach Anspruch 1,
bei dem die Schutzdiode (4) mittels eines Metall-Halbleiter-Übergangs ausgebildet ist, wobei die Hauptfläche (51) den Metall-Halbleiter-Übergang bildet.

4. Halbleiterchip nach Anspruch 1,
bei dem die erste Anschlussschicht (31) eine Injektionsschicht (310) und eine Übergangsschicht (311) aufweist, wobei die Injektionsschicht an den Halbleiterkörper (2) und die Übergangsschicht (311) an den Träger (5) angrenzt.

5. Halbleiterchip nach dem vorhergehenden Anspruch,
bei dem die Schutzdiode (4) mittels der Übergangsschicht (311) gebildet ist.

6. Halbleiterchip nach Anspruch 1,
bei dem die zweite Anschlussschicht (32) bereichsweise zwischen der ersten Anschlussschicht (31) und dem Träger (5) ausgebildet ist.

7. Halbleiterchip nach einem der vorhergehenden Ansprüche,
bei dem die Schutzdiode (4) in Aufsicht auf den Halbleiterchip (1) mit dem ersten Kontakt (35) überlappt.

8. Halbleiterchip nach einem der vorhergehenden Ansprüche,
bei dem der Träger (5) ein Halbleitermaterial enthält.

## Claims

1. A radiation-emitting semiconductor chip (1), which has a carrier (5), a semiconductor body (2) having a semiconductor layer sequence, a first contact (35) and a second contact (36), wherein
- the semiconductor layer sequence comprises an active region (20) intended for generating radiation, the active region (20) is arranged between a first semiconductor layer (21) and a second semiconductor layer (22);
- the carrier (5) has a main surface (51) facing the semiconductor body (2);
- a growth substrate for the semiconductor layer sequence of the semiconductor body (2) is removed and the carrier (5) mechanically stabilizes the semiconductor body;
- the first semiconductor layer (21) is arranged on the side facing the main surface (51) of the carrier (5) and can be electrically contacted by means of the first contact (35);
- the second semiconductor layer (22) can be electrically contacted by means of the second contact;
- a protective diode (4) is formed in a current path which runs between the first contact (35) and the second contact (36) through the carrier (5);
- the first contact (35) is connected to the first semiconductor layer (21) via a first connection layer (31) in an electrically conductively manner, and the first connection layer (31) is arranged between the semiconductor body (2) and the carrier (5);
- the semiconductor body (2) has at least one recess which extends through the active region (20) and which is provided for electrically contacting the second semiconductor layer (22), and
- the second semiconductor layer (22) is connected to a second connection layer (32) in an electrically conductively manner, and the second connection layer (32) extends through the recess (25),
**characterized in that**
- the first connection layer (31) and the second connection layer (32) are arranged in succession between the carrier (5) and the semiconductor body, so that the second connection layer (32) is closer to the carrier (5) than the first connection layer (31),
- the first contact (35) and the second contact (36) are arranged on different sides of the carrier (5), and
- the semiconductor body (2) is connected to the carrier (5) in a substance-locking manner.

2. The semiconductor chip according to claim 1,
in which the protective diode (4) is a Schottky diode which is formed between the first contact (35) and the carrier (5).

3. The semiconductor chip according to claim 1,
in which the protective diode (4) is formed by means of a metal-semiconductor junction, wherein the main surface (51) forms the metal-semiconductor junction.

4. The semiconductor chip according to claim 1,
in which the first connection layer (31) comprises an injection layer (310) and a transition layer (311), wherein the injection layer adjoins the semiconductor body (2) and the transition layer (311) adjoins the carrier (5).

5. The semiconductor chip according to the preceding claim,
in which the protective diode (4) is formed by means of the transition layer (311).

6. The semiconductor chip according to claim 1,
in which the second connection layer (32) is formed in regions between the first connection layer (31) and the carrier (5).

7. The semiconductor chip according to one of the preceding claims,
in which the protective diode (4) overlaps the first contact (35) seen in a plan view of the semiconductor chip (1).

8. The semiconductor chip according to one of the preceding claims,
in which the carrier (5) contains a semiconductor material.

## Revendications

1. Puce électronique à semiconducteur émettant une radiation (1), qui présente un support (5), un corps de semiconducteur (2) avec une succession de couches semiconductrices, un premier contact (35) et un second contact (36), sachant que
- la succession de couches semiconductrices présente une zone active (20) prévue pour la production de rayonnement, qui est disposée entre une première couche semiconductrice (21) et une seconde couche semiconductrice (22) ;
- le support (5) présente une surface principale (51) tournée vers le corps de semiconducteur (2) ;
- pour laquelle un substrat épitaxique pour la succession de couches semiconductrices est éloigné du corps de semiconducteur (2) et le support (5) stabilise mécaniquement le corps de semiconducteur ;
- la première couche semiconductrice (21) est disposée sur le côté de la zone active (20) tourné vers la surface principale (51) du support (5) et est susceptible d'être mise en contact électrique au moyen du premier contact (35) ;
- la seconde couche semiconductrice (22) est susceptible d'être mise en contact électrique au moyen du second contact (36) ;
- une diode de protection (4) est constituée dans une voie du courant, qui se déploie entre le premier contact (35) et le second contact (36) à travers le support (5) ;
- le premier contact (35) est relié de manière électriquement conductrice via une première couche de raccordement (31) avec la première couche semiconductrice (21), et la première couche de raccordement (31) est disposée entre le corps de semiconducteur (2) et le support (5) ;
- le corps de semiconducteur (2) présente au moins un creux (25), qui s'étend à travers la zone active (20) et qui est prévu pour la mise en contact électrique de la seconde couche
semiconductrice (22), et
- la seconde couche semiconductrice (22) est relié de manière électriquement conductrice avec une seconde couche de raccordement (32) et que la seconde couche de raccordement (32) s'étend à travers le creux (25),
**caractérisée en ce que**
- la première couche de raccordement (31) et la seconde couche de raccordement (32) se trouvent successivement entre le support (5) et le corps de semiconducteur, de sorte que la seconde couche de raccordement (32) se trouve plus près du support (5) que la première couche de raccordement (31),
- le premier contact (35) et le second contact (36) sont disposés sur des côtés différents du support (5), et
- le corps de semiconducteur (2) est relié par adhésion de matière au support (5).

2. Puce électronique à semiconducteur selon la revendication 1,
sur laquelle la diode de protection (4) est une diode Schottky, qui est constituée entre le premier contact (35) et le support (5).

3. Puce électronique à semiconducteur selon la revendication 1,
sur laquelle la diode de protection (4) est constituée au moyen d'une jonction métallique de semiconducteur, sachant que la surface principale (51) constitue la jonction métallique de semiconducteur.

4. Puce électronique à semiconducteur selon la revendication 1,
sur laquelle une première couche de raccordement (31) présente une couche d'injection (310) et une couche de transition (311), sachant que la couche d'injection est adjacente au corps de semiconducteur (2) et la couche de transition (311) au support (5).

5. Puce électronique à semiconducteur selon la revendication précédente,
sur laquelle la diode de protection (4) est constituée au moyen de la couche de transition (311).

6. Puce électronique à semiconducteur selon la revendication 1,
sur laquelle la seconde couche de raccordement (32) est constituée par zone entre la première couche de raccordement (31) et le support.

7. Puce électronique à semiconducteur selon une quelconque des revendications précédentes,
sur laquelle la diode de protection (4) se chevauche par le haut sur la puce électronique à semiconducteur (1) avec le premier contact (35).

8. Puce électronique à semiconducteur selon une quelconque des revendications précédentes,
sur laquelle le support (5) contient un matériau de semiconducteur.
